# EUROPÄISCHE PATENTANMELDUNG

(11) **EP 1 176 634 A2**
(43) Veröffentlichungstag der Anmeldung: **30.01.2002**
(21) Anmeldenummer: 01115152.9
(22) Anmeldetag: 22.06.2001
(51) Int. Cl.: H01L 21/3105, H01L 21/027, G03F 7/09

(54) **Verfahren zum anisotropen Trockenätzen von organischer Antireflexionsschichten**

(30) Priorität: 27.07.2000 DE 10037957
(71) Anmelder: Infineon Technologies AG, 81669 München (DE)
(72) Erfinder: Richter, Harald, 15234 Frankfurt (DE); Wege, Stephan, 01474 Weissig (DE); Stegemann, Maik, 01157 Dresden (DE)
(74) Vertreter: Patentanwaltskanzlei WILHELM & BECK

(57) **Zusammenfassung**

Bei einem Verfahren zum anisotropen Trockenätzen einer organischen Antireflexionsschicht werden als Ätzgase im wesentlichen Wassersstoff und Stickstoff eingesetzt.

## Beschreibung

Die Erfindung betrifft ein Verfahren zum anisotropen Trockenätzen einer organischen Antireflexionsschicht.

Integrierte Schaltungen auf Halbleiterscheiben, vor allem aus Siliciumscheiben, werden mit Hilfe der Planartechnik hergestellt. Die Strukturierung der Halbleiterschichten zur Ausbildung der einzelnen Bauteile erfolgt dabei fast durchwegs mit Hilfe der lithographischen Technik. Die gewünschten Bauteilstrukturen werden dabei zunächst über eine Photomaske in einem dünnen, strahlungsempfindlichen Film, meist einer organischen Photolackschicht, auf der oxidierten Halbleiterscheibe erzeugt und mit Hilfe spezieller Ätzverfahren in die darunterliegenden Schichten übertragen. Die Bestrahlung der Photolackschicht erfolgt mit schmalbandigem Licht, wobei vor allem Quecksilber-Hochdrucklampen oder Laser eingesetzt werden. Bei der Belichtung kommt es jedoch oft zu ausgeprägten Interferenzeffekten zwischen den einfallenden und an den Halbleiterscheiben reflektierten Lichtwellen, die zu Linienbreitenschwankungen des Lichts auf der Photolackschicht führen. Diese Linienbreitenschwankung wiederum verkleinern oder vergrößern die auf den Photolack mit der Maske übertragene Struktur in ungewünschter Weise.

Zur Reduzierung der Interferenzeffekte werden Antireflexionsschichten zwischen dem Halbleitersubstrat und der Photolackschicht aufgebracht, die die vom Halbleitersubstrat in die Photolackschicht zurückreflektierte Lichtwellen absorbieren bzw. durch destruktive Interferenz auslöschen. Hierbei werden insbesondere aus organischen Polymeren bestehende Antireflexionsschichten eingesetzt, die sich durch eine hohe Lichtabsorption auszeichnen. Organische Antireflexionsschichten eignen sich darüber hinaus auch zum Planarisieren von Kanten und Stufen in den Halbleiterschichten. Eine solche Einebnung ist oft insbesondere vor dem Aufbringen einer Metallebene, in der Leiterbahnen zur Verdrahtung der Bauteile des Halbleiterchips ausgebildet werden, erforderlich. Aufgrund der begrenzten Konformität der herkömmlicherweise verwendeten Metallsputterbeschichtung kann nämlich die Dicke der Metallisierung an steilen Kanten auf der Halbleiteroberfläche so niedrig sein, dass die Leiterbahnquerschnitte deutlich geringer als auf planaren Oberflächen ausfallen. In solchen Bereichen treten dann unerwünscht hohe Stromstärken auf. Die verschiedenen Möglichkeiten der Photolacktechnik mit Antireflexionsschicht sind u.a. in Widmann, D./Mader, H./Friedrich H.: Technologie hochintegrierter Schaltungen, 1996, Springer beschrieben.

Eine Variante der Photolacktechnik mit Antireflexionsschicht ist die sogenannte Trilevel-Resist-Technik. Hier wird eine sogenannte Bottom-Resist-Schicht auf das Halbleitersubstrat aufgeschleudert, die ein Positiv-Resist oder dessen Harz ist, das durch einen Absorberzusatz oder durch hohes Ausheizen stark lichtabsorbierend gemacht werden kann. Auf diese sogenannte Bottom-Resist-Schicht wird eine Spin-On-Glas-Zwischenschicht und anschließend eine sogenannte Top-Resist-Schicht aufgebracht. Diese oberste Top-Resist-Schicht ist die eigentlich photochemisch aktive Schicht. Die Bottom-Resist-Schicht dagegen sorgt dafür, dass praktisch kein Licht vom Halbleitersubstrat in diese Top-Resist-Schicht zurückreflektiert wird. Weiterhin wird die Bottom-Resist-Schicht auch ausreichend dick gemacht, um auf dem Halbleiter-Substrat vorhandene steile Stufen einzuebnen, so dass die Top-Resist-Schicht mit einer von diesen Oberflächenstufen unbeeinflussten, gleichmäßigen Dicke ausgeschleudert werden kann. Die Top-Resist-Schicht wird anschließend über eine Maske, die die gewünschte Halbleiterbauteil-Struktur enthält, belichtet und entwickelt. Durch die Entwicklung löst sich die Top-Resist-Schicht an den belichteten Stellen auf, die nicht bestrahlten Bereiche dagegen bleiben maskiert. Anschließend wird die Spin-On-Glas-Zwischenschicht an den freigelegten Stellen geätzt. Letztere dient dann als Ätzmaske beim anisotropen Ätzen der Bottom-Resist-Schicht, die schließlich wiederum als Maskierungsschicht zum Ätzen der darunterliegenden, zu strukturierenden Halbleiterschicht, z.B. Siliciumdioxid, eingesetzt wird.

Alternativ zu diesem Trilevel-Resist-Aufbau kann auch eine Bilevel-Resist-Technik eingesetzt werden, bei der auf die Spin-On-Glas-Zwischenschicht verzichtet ist. Dies ist dann möglich, wenn die Top-Resist-Struktur ätzresistent gegenüber der Bottom-Resist-Ätzung ist.

Die Öffnung der organischen Antireflexionsschicht erfolgt herkömmlicherweise mit Hilfe von Trockenätztechniken, wobei folgende Anforderungen an das Ätzverfahren gestellt werden: Der Anisotropiefaktor der Ätzung soll möglichst nahe bei 1 liegen, um eine hohe Profiltreue, d.h. steile Lackflanken zu erzielen. Weiterhin soll die Maskenstruktur möglichst genau auf die unter der organischen Antireflexionsschicht liegende Halbleiterschicht übertragen werden, d.h. die Ätzung soll CD (Critical Dimension) treu sein. Schlussendlich wird von der Ätzung eine hohe Selektivität zur Maskeschicht und zur unter der zu ätzenden Schicht liegenden Halbleiterschicht gefordert.

Das Trockenätzverfahren nutzt üblicherweise gasförmige Medien, die durch eine Gasentladung im hochfrequenten Wechselfeld angeregt werden. Der Entladungsvorgang findet im Unterdruckbereich statt, so dass eine große freie Weglänge der Ionen zwischen zwei Stößen erreicht wird. Zur Erzielung hochfeiner Strukturen wird vor allem der chemisch-physikalische Trockenätzprozess eingesetzt, bei dem neben einem rein physikalischen Materialabtrag durch Herausschlagen von Atomen bzw. Molekülen aus der zu ätzenden Schicht ein chemischer Materialabtrag durch ein reaktives Gas erfolgt. Das wichtigste Ätzverfahren beim chemisch-physikalischen Trockenätzen ist dabei das reaktive Ionenätzen, wobei zum anisotropen Ätzen von organischer Antireflexionsschicht als Reaktionsgas vor allem Sauerstoff genutzt wird, da Sauerstoff mit den Polymerbestandteilen flüchtige Reaktionsprodukte bildet.

Da der Sauerstoff jedoch ein sehr isotropes Ätzverhalten und eine schlechte Selektivität zeigt, sind dem Sauerstoff im allgemeinen weitere Gase zum Verbessern des Ätzverhaltens zugemischt. Hierbei werden vor allem Chlor oder Stickstoff genutzt, wobei sich jedoch weiterhin bei einer solchen Ätzgaschemie nicht alle Anforderungen an den Ätzprozess erfüllen lassen.

Eine physikalisch-chemische Trockenätzung mit einer Sauerstoff-Chlor-Chemie zeichnet sich zwar durch eine strukturgenaue Übertragung der Maskenstruktur im Ätzprozess auf die unter der organischen Antireflexionsschicht liegende Halbleiterstruktur aus. Die Profilgenauigkeit dagegen ist gering und darüber hinaus tritt ein unerwünschtes Mitätzen der Halbleiterschicht auf. Beim Einsatz einer Sauerstoff-Stickstoff-Chemie zum chemisch-physikalischen Trockenätzen einer organischen Antireflexionsschicht kann zwar eine verbesserte Selektivität zum Halbleiteruntergrund unter der Antireflexionsschicht erreicht werden, die CD-Treue dagegen niedrig ist.

Die Ätzung der organischen Antireflexionsschicht mit Chlor als Reaktionsbestandteil ist darüber hinaus im allgemeinen nicht verträglich mit der nachfolgenden Chemie zur Halbleiterschicht-Ätzung, insbesondere dann, wenn eine Siliciumdioxid-Schicht geätzt werden soll. Die Reaktionsprodukte des Sauerstoffs mit den Polymerbestandteilen der organischen Antireflexionsschicht lassen sich nämlich nur sehr schwer aus der Ätzkammer entfernen und verbinden sich dann mit der Ätzchemie des nachfolgenden Halbleiter-Ätzprozess, wodurch sich die Ätzparameter und damit die Ätzstruktur in unerwünschter Weise verändern.

Aus der Jpn. J. Appl. Phys. Part 1, Vol. 32 (1993), Seiten 747 bis 752 ist ein Verfahren zum Entfernen von Photolack (Strippen) bekannt, bei dem das Ätzgas aus O₂-CF₄ besteht und einen Zusatz von N2-H2 enthält. Das Verfahren wird in einer MRIE-Vorrichtung durchgeführt. Aus der JP 11-150 115 A und der US 5 910453 ist weiter das Ätzen von organischen ARC-Schichten mit O₂ bzw. O₂-H₂-Ar bekannt ist.

Aufgabe der vorliegenden Erfindung ist es, ein Verfahren zum anisotropen Trockenätzen einer organischen Antireflexionsschicht bereitzustellen, das sich durch eine hohe Selektivität, eine verbesserte Strukturtreue sowie eine gute Verträglichkeit mit nachfolgenden Ätzprozessen auszeichnet.

Diese Aufgabe wird erfindungsgemäß durch das im Anspruch 1 angegebene Verfahren gelöst. Bevorzugte Weiterbildungen sind in den abhängigen Ansprüchen angegeben.

Bei dem erfindungsgemäßen Verfahren zum anisotropen Trockenätzen der organischen Antireflexionsschicht werden als Ätzgase im wesentlichen Wasserstoff und Stickstoff eingesetzt. Mit dieser Ätzchemie ist ein physikalisch-chemisches Trockenätzen möglich, bei dem ein Anätzen der unter der organischen Antireflexionsschicht liegenden Halbleiterschicht weitgehend verhindert wird. So lässt sich mit der Ätzchemie, die als reaktive Ätzgase gemäß einer bevorzugten Ausführungsform mindestens 80% Stickstoff und Wasserstoff enthält, eine Selektivität der organischen Antireflexionsschicht-Ätzung zur Ätzung der darunterliegenden Halbleiterschicht von über 1 : 50 erreichen. Weiterhin gewährleistet die Reaktionsgaszusammensetzung aus Stickstoff und Wasserstoff eine strukturgenaue Übertragung der Ätzmaske sowie eine hohe Profiltreue der Lackflanken. Schlussendlich wird mit einem Wasserstoff-Stickstoff-Gemisch als Reaktionsgase zur Ätzung der organischen Antireflexionsschicht auch eine gute Verträglichkeit mit der nachfolgenden Halbleiterschicht-Ätzung, insbesondere der Siliciumdioxid-Ätzung, erreicht, so dass die Ätzvorgänge in der gleichen Reaktionskammer ausgeführt werden können.

Gemäß einer bevorzugten Ausführungsform setzt sich das Reaktionsgas aus gleichen Anteilen von Wasserstoff und Stickstoff zusammen. Dieses Reaktionsgasgemisch ermöglicht eine hochgenaue anisotrope Ätzung der organischen Antireflexionsschicht auch bei sehr großen Schichtdicken, wie sie insbesondere dann gegeben sind, wenn die organische Antireflexionsschicht zusätzlich zum Planarisieren von Stufen und Kanten der darunterliegenden Halbleiterschicht eingesetzt wird. Die organische Antireflexionsschicht kann mit einer solchen Reaktionsgas-Zusammensetzung strukturgenau auch bei einer starken Überätzung geöffnet werden, ohne dass oder der Halbleiteruntergrund angegriffen wird. Es lassen sich dabei insbesondere auch Strukturen unterhalb 0,2 µm zuverlässig erzeugen.

Gemäß einer weiteren bevorzugten Ausführungsform ist dann, wenn als Ätzmaske für die organische Reflexionsschicht eine Photolackschicht eingesetzt wird, wird die Ätzgaszusammensetzung mit Wasserstoff und Stickstoff so eingestellt, dass der vertikale Abbag maximal der Ätzrate der organischen Antireflexionsschicht entspricht. Hierdurch wird erreicht, dass nur eine geringe Facettierung der als Ätzmaske eingesetzten Photolackschicht beim Ätzen auftritt und die darunterliegende organische Antireflexionsschicht nach dem Ätzvorgang weiterhin steile Flanke aufweist.

Gemäß einer weiteren bevorzugten Ausführungsform wird die physikalisch-chemische Trockenätzung mit einem Reaktionsgas-Gemisch aus Wasserstoff und Stickstoff in reaktiver Ionenätztechnik bei einem Druckbereich von 2,67 bis 26,67 Pa (20 bis 200 mTorr) und einem Gasfluss von 0,17 bis 1,67 10⁻⁶ m³sec⁻¹ (10 bis 100 sccm) ausgeführt. Bei einem solchen Ätzprozess lässt sich das Ätzverhalten besonders gut in Bezug auf Homogenität, Ätzrate, Ätzprofil und Selektivität steuern und darüber hinaus eine hohe Reproduzierbarkeit erreichen. Weiterhin ist es bevorzugt, das reaktive Ionenätzen magnetfeldunterstützt bei einem Magnetfeld von bis zu 120 Gauss auszuführen. Die Erfindung wird anhand der beigefügten Zeichnungen näher erläutert. Es zeigen:
- Fig. 1A-D: schematische Darstellungen der Prozessschritte einer Lithographie mit einer organischer Antireflexionsschicht;
- Fig. 2: den Aufbau eines Parallelplattenreaktors zum magnetfeldunterstützten reaktiven Ionenätzen;
- Fig. 3A/B: Vergleichsaufnahmen einer Ätzung einer organischen Antireflexionsschicht mit einer Chlor-Sauerstoff-Chemie und der erfindungsgemäßen Wasserstoff-Stickstoff-Chemie;
- Fig. 4A/B: Vergleichaufnahmen der Ätzung der ersten Metallebene nach dem Öffnen der organischen Antireflexionsschicht mit einer Chlor-Sauerstoff-Chemie bzw. der erfindungsgemäßen Wasserstoff-StickstoffChemie; und
- Fig. 5A-D: Aufnahmen von der Ätzung einer organischen Antireflexionsschicht mit der erfindungsgemäßen Wasserstoff-Stickstoff-Chemie nach verschiedenen Ätzzeiten.

In der Planartechnik zur Herstellung integrierter Halbleiterschaltungen erfolgt die lokale Bearbeitung der Halbleiterschaltungen mit Hilfe lithographischer Verfahren. Die gewünschten Strukturen werden dabei zunächst über eine Photomaske in einem dünnen strahlungsempfindlichen Film auf der oxidierten Halbleiterscheibe erzeugt und dann mit Hilfe spezieller Ätzverfahren in die darunterliegenden Schichten übertragen. Die Photolackschicht soll dabei verschiedenste Anforderungen erfüllen. So soll ein hoher Photolackkontrast und eine hohe Empfindlichkeit, d.h. kurze Belichtungszeiten, gegeben sein. Weiterhin soll die Photolackschicht nur eine geringe Lichtabsorption zeigen und darüber hinaus sollen Interferenzeffekte zwischen ein- und ausfallenden Lichtwellen vermieden werden. Außerdem werden eine hohe Formstabilität der Photolack-Strukturen beim reaktiven Ionenätzen sowie eine gute Entfernbarkeit der Photolackmaske gewünscht.

Um die verschiedenen Anforderungen an den Photolack erfüllen zu können, werden Photolacksysteme eingesetzt, die sich aus mehreren Schichten zusammensetzen. Insbesondere wird zwischen dem Halbleitersubstrat und der lichtempfindlichen PhotolackSchicht eine Antireflexionsschicht eingebracht, um die vom Substrat in den Photolack zurückreflektierte Lichtwelle zu schwächen und damit die Interferenzeffekte weitgehend auszuschalten.

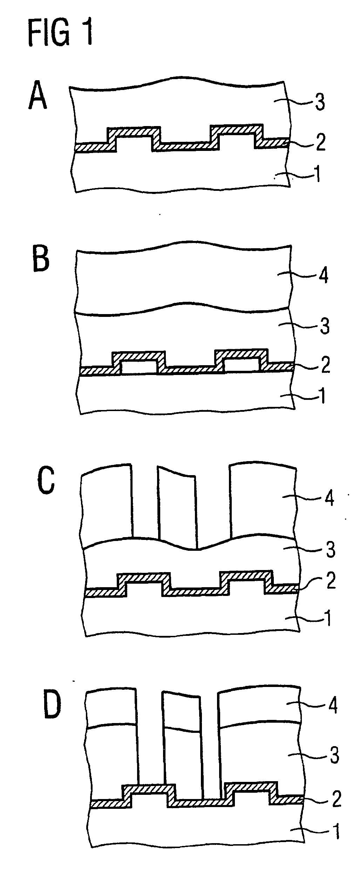

In Fig. 1A-D sind schematische Querschnitte der Prozessschritte einer Bilevel-Photolack-Technik mit einer Antireflexionsschicht gezeigt. Auf die oberste Schicht 2 des Halbleitersubstrats 1, die im allgemeinen eine Siliciumdioxid-Schicht ist, wird, wie in Fig. 1A dargestellt ist, die organische Antireflexionsschicht 3 aufgesputtert. Als organische Antireflexionsschicht 3 wird dabei ein im wesentlichen den Photolacken ähnliches Material eingesetzt, das durch einen Absorberzusatz oder durch Ausheizen auf 200° stark absorbierend gemacht wird. Eine solche organische Antireflexionsschicht 3 sorgt dann dafür, dass praktisch kein Licht mehr von der Halbleiteroberfläche zurückreflektiert wird. Weiterhin wird die Antireflexionsschicht 3 vorzugsweise so dick gemacht, dass die auf der Halbleiteroberfläche vorhandenen steilen Stufen eingeebnet werden können. Die organische Antireflexionsschicht 3 dient somit auch zur Planarisierung, wie sie insbesondere vor der Ausbildung der Metallisierungsebenen erforderlich ist. Auf die organische Antireflexionsschicht 3 wird dann, wie in Fig. 1B gezeigt, die eigentliche Photolackschicht 4 aufgeschleudert. Diese Photolackschicht 4 wird anschließend mit einem Laser oder einer Quecksilber-Hochdruckdampflampe bestrahlt, wobei die Photolackschicht 4 durch Zwischenschaltung einer Maske nur in den gewünschten Bereichen belichtet wird.

Anschließend werden die bestrahlten Bereiche der Photolackschicht 4 entfernt. Dies ist in Fig. 1C dargestellt.

Die Photolackschicht 4 dient dann als Ätzmaske für die darunterliegende organische Antireflexionsschicht 3. Die Ätzung der organischen Antireflexionsschicht 3 erfolgt dabei insbesondere mit Hilfe der chemisch-physikalischen Trockenätzung, da sich hierbei sehr feine Strukturen erzeugen lassen, wie sie insbesondere zur Ausbildung von Bauteilbreiten von unter 0,2 µm benötigt werden. Bei diesem Verfahren wird durch Beschuss insbesondere mit Ionen auf der zu ätzenden Schichtoberfläche eine chemisch-physikalische Ätzreaktion ausgelöst. Erfolgt der Teilchenbeschuss dabei senkrecht, so kann die Maskenstruktur maßhaltig in die darunterliegende Schicht übertragen werden, wobei dies in Fig. 1D gezeigt ist.

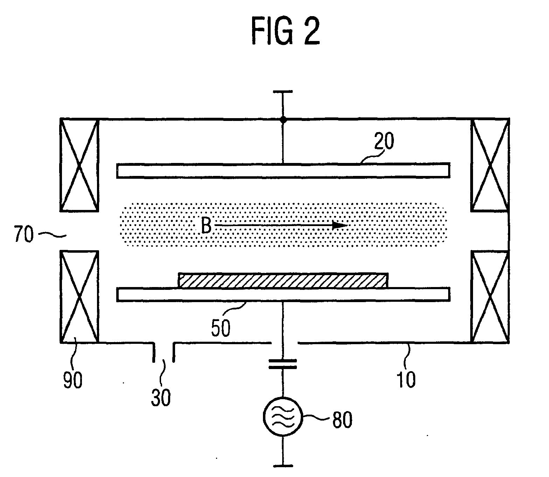

Fig. 2 zeigt einen Ätzreaktor für einen anisotropen Ätzprozess bei einer organischen Antireflexionsschicht. Der Reaktor besteht im wesentlichen aus einer Vakuumkammer 10 mit einem Einlaß 70 für das Ätzgas, einen Anschluss 30 für die Vakuumpumpe und zwei parallelen Elektroden 20, 50. Die zu ätzende Halbleiterscheibe befindet sich auf einer der beiden Elektroden, im gezeigten Fall auf der unteren Elektrode 50. Die untere Elektrode 50 ist weiterhin kapazitiv mit einer Hochspannung 80 gekoppelt. Die obere Elektrode 20 ist mit der Vakuumkammer 10 verbunden und geerdet. Dem vorher evakuierten Vakuumraum 10 wird über den Einlass 70 das für das zu ätzende Material geeignete Ätzgas zugeführt. Gemäß der Erfindung wird zum Ätzen der organischen Antireflexionsschicht 3 ein im wesentlichen aus Stickstoff und Wasserstoff bestehendes Ätzgasgemisch verwendet. Das Ätzgasgemisch weist dabei als reaktive Ätzgase vorzugsweise mindestens 80% Wasserstoff und Stickstoff auf. Das Verhältnis von Wasserstoff und Stickstoff beträgt dabei vorzugsweise 1:1. Das Ätzgasgemisch kann weiterhin Additive enthalten, die die Ätzgaseigenschaften in Bezug auf die Gegebenheiten des jeweils verwendeten Trockenätzverfahrens verbessern. Die in den Zeichnungen dargestellten chemischpysikalischen Trockenätzverfahren in Form eines reaktiven Ionenätzens wird ein Ätzgasgemisch eingesetzt, dass neben unvermeidlichen Verunreinigungen nur aus Wasserstoff und Sauerstoff besteht, die jeweils in gleichen Anteilen vorliegen.

Mit einer Regelelektronik am Reaktor wird der Druck und die Gasflussrate im wesentlichen konstant gehalten. Der Druckbereich zum Ätzen der organischen Antireflexionsschicht 3 liegt dabei vorzugsweise im Bereich von 2,67 bis 26,67 Pa (20 bis 200 mTorr). Die Gasflussrate ist vorzugsweise auf 0,17 bis 1,67 10⁻⁶ m³sec⁻¹ (10 bis 100 sccm) eingestellt. Durch eine angelegte Hochspannung wird das Ätzgasgemisch zwischen den Elektroden 20, 50 zur Glimmentladung gebracht. Es entsteht ein Niederdruck-Niedertemperatur-Plasma mit Ionen und Elektronen. Da die obere Elektrode 20 mit der Vakuumkammer 10 verbunden und geerdet ist, hat die obere Elektrode 20 eine größere Oberfläche als die untere Elektrode 50. Das hat zur Folge, dass sich die untere Elektrode 50 stärker negativ auflädt als die obere Elektrode 20. Die Ionen aus dem Plasma erhalten damit auf dem Weg zur zu ätzenden Halbleiterscheibe eine genügend kinetische Energie zur Auslösung einer chemischen Reaktion mit der organischen Antireflexionsschicht 3. Sie gelangen dabei senkrecht zur zu ätzenden Oberfläche und übertragen so die durch die Photolackschicht 4 vorgegebene Maske maßhaltig in die organische Antireflexionsschicht. Die Ätzung wird vorzugsweise, wie in Fig. 2 gezeigt ist, durch ein Magnetfeld, das von Magneten 90 in der Vakuumkammer 10 erzeugt wird, unterstützt. Das Magnetfeld verdichtet über der zu ätzenden Schicht das Plasma. Dadurch wird die Anzahl der zum Ätzen zur Verfügung stehenden Ionen wesentlich erhöht. Es kann dabei ein Magnetfeld bis zu 120 Gauss eingesetzt werden.

Durch den erfindungsgemäßen Einsatz einer Wasserstoff-Stickstoff-Chemie ist es möglich, eine hohe Selektivität bei der Ätzung der organischen Antireflexionsschicht 3 zu erreichen. Da im allgemeinen die Dichte der Antireflexionsschichten aufgrund der darunterliegenden Topologie stark schwankt, muss in manchen Bereichen der Antireflexionsschicht eine starke Überätzung durchgeführt werden. Der Einsatz einer Stickstoff-Wasserstoff-Chemie zum Ätzen der organischen Antireflexionsschicht sorgt dafür, dass auch bei unterschiedlichsten Dicken dieser Antireflexionsschicht die darunterliegende Halbleiterschicht nicht angeätzt wird. So lässt sich bei einer organischen Antireflexionsschicht und einer darunterliegenden Oxidschicht mit einer Wasserstoff-Stickstoff-Chemie eine Selektivität von 50 : 1 erzielen. Das Ätzen der organischen Antireflexionsschicht mit einem Ätzgasgemisch aus Wasserstoff und Stickstoff sorgt darüber hinaus für eine hochgenaue Übertragung der vom Photolack vorgegebenen Maske auf die darunterliegende Halbleiterschicht. Die Ätzung ist absolut profiltreu mit steilen Lackflanken, so dass ein Anisotropiefaktor von im wesentlichen 1 erreicht wird. Weiterhin werden Verluste der organischen Antireflexionsschicht beim Übertragen der Photolackmaske auf die unter der organischen Antireflexionsschicht liegende Halbleiterschicht zuverlässig verhindert, d.h. eine hohe CD-Treue wird erreicht.

Der Einsatz der Wasserstoff-Stickstoff-Chemie ermöglicht darüber hinaus die Ätzung der unter der organischen Antireflexionsschicht liegenden Halbleiterschicht, bei der die organische Antireflexionsschicht als Maskierungsschicht dient in ein und demselben Ätzreaktor. Die Ätzung der im allgemeinen unter der organischen Antireflexionsschicht liegenden Siliciumdioxidschicht erfolgt vorzugsweise ebenfalls durch magnetfeldunterstütztes reaktives Ionenätzen, wobei ein typischer Oxidätzprozeß mit folgenden Prozessbedingungen durchgeführt wird. Der Druck in der Vakuumkammer beträgt ca. 20 Pa (150 mTorr). Als Ätzgase werden CHF₃ und CF₄ eingesetzt, wobei der Gasfluss 0,58 10⁻⁶ m³sec⁻¹ (35 sccm) bzw. 0,42 10⁻⁶ m³sec⁻¹ (25 sccm) beträgt. Weiterhin wird zur Verbesserung des Ätzverhaltens Argon mit einer Flussrate von 2,5 10⁻⁶ m³sec⁻¹ (ca. 150 sccm) eingespeist. Das Magnetfeld zur Unterstützung des Ätzens beträgt vorzugsweise 15 Gauss. Mit der bisher standardmäßig verwendeten Chemie zur Ätzung der organischen Antireflexionsschicht war die nachfolgende Ätzung einer darunterliegenden Oxidschicht in der gleichen Ätzkammer nicht möglich, da die Chemie zur Ätzung der organischen Antireflexionsschicht mit der Chemie der nachfolgenden Oxidätzung unverträglich war. Durch die erfindungsgemäße Verwendung der Wasserstoff-Stickstoff-Chemie, die den Einsatz der hierfür verwendeten Ätzkammer für die darauffolgende Oxidätzung ermöglicht, wird ein wesentlicher Zeit- und Kostenspareffekt erreicht.

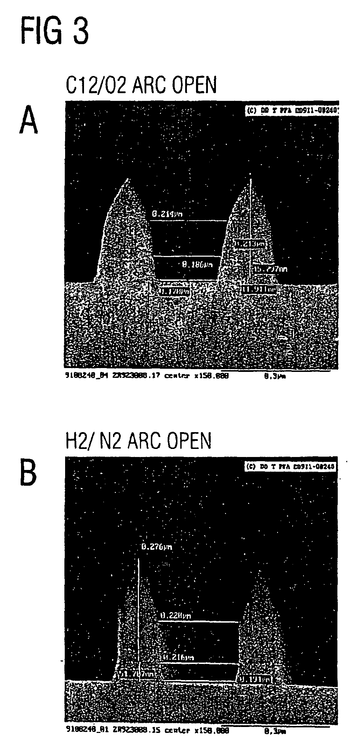

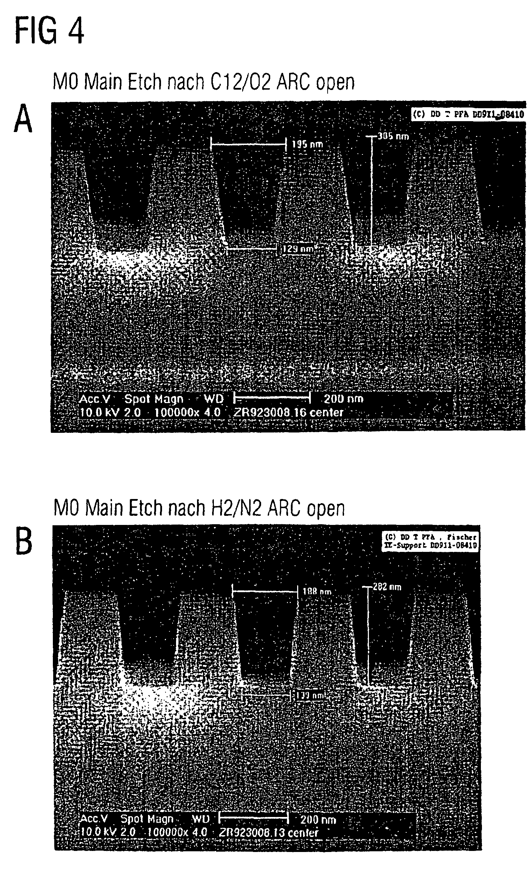

Fig. 3 und 4 zeigen Elektronenmikroskopaufnahmen einer Lithographie zur Strukturierung der ersten Metallisierungsebene in einer integrierten Halbleiterschaltung mit der herkömmlichen Chlor-Sauerstoff-Chemie sowie mit der erfindungsgemäßen Wasserstoff-Stickstoff-Chemie. In Fig. 3A ist ein Querschnitt durch ein Bilevel-Photolacksystem auf einer Siliciumdioxid-Schicht nach dem Öffnen der Antireflexionsschicht mit Hilfe einer herkömmlichen Chlor-Sauerstoff-Chemie gezeigt. Fig. 3B stellt den gleichen Aufbau nach dem Öffnen mit der erfindungsgemäßen Wasserstoff-Stickstoff-Chemie dar. Wie ein Vergleich der Figuren zeigt, tritt bei der Öffnung der organischen Antireflexionsschicht mit Hilfe der Chlor-Sauerstoff-Chemie eine leichte Anätzung der Siliciumoxid-Schicht auf. Die Wasserstoff-Stickstoff-Chemie dagegen ist absolut selektiv zur Siliciumoxid-Schicht. Weiterhin ist bei der Chlor-Sauerstoff-Ätzung eine starke Facettierung sowohl der Flanken des Photolacks als auch der organischen Antireflexionsschicht festzustellen, wobei die Breite des Ätzprofils zusätzlich höhenabhängig ist. Bei Einsatz der Wasserstoff-Stickstoff-Chemie dagegen tritt nur eine Facettierung im Bereich der oberen Photolackschicht auf. Die darunterliegende organische Antireflexionsschicht weist dagegen steile Flanken auf, wobei die Breite des geätzten Grabens stabil bleibt, so dass ein Anisotropiefaktor von nahezu 1 erreicht wird.

Fig. 4A und 4B zeigen jeweils die auf die Öffnung der Antireflexionsschicht erfolgende Ätzung zur Strukturierung der ersten Metallisierungsebene, wobei die als Maskenschicht verwendete organische Antireflexionsschicht bereits entfernt ist. Wenn die erfindungsgemäße Wasserstoff-Stickstoff-Chemie, wie in Fig. 4B gezeigt ist, zur Öffnung der organischen Antireflexionsschicht verwendet wird, ergibt die darauffolgende Ätzung zur Strukturierung der Metalllage eindeutig ein verbessertes Profil der Metallbahnen.

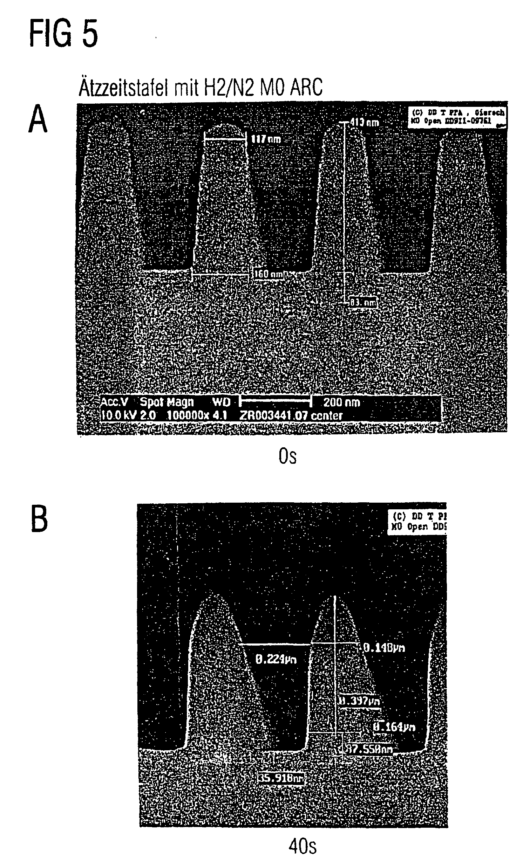

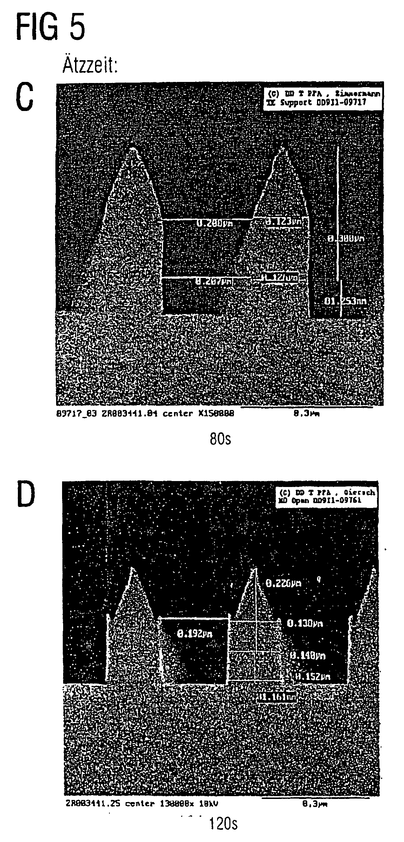

Fig. 5 zeigt Elektronenmikroskopaufnahmen zur Öffnung der organischen Antireflexionsschicht und zwar in Fig. 5A vor der Ätzung, in der Fig. 5B nach einer Ätzzeit von 40 sec, in Fig. 5C nach einer Ätzzeit von 80 sec und in Fig. 5D nach einer Ätzzeit von 120 sec.. Es ist deutlich zu sehen, dass zwar die vertikale Erosion der obenliegenden Photolackschicht mit der Ätzzeit zunimmt, die Ätzbreite jedoch unabhängig von der Ätzzeit konstant bleibt, somit also eine vollkommene CD-treue Ätzung erreicht wird. Weiterhin bleiben auch die Flankenform der Lack- und der organischen Antireflexionsschicht weitgehend erhalten, wobei jedoch die Höhe der senkrechten Seitenwand mit der Zeit abnimmt.

Mit dem Einsatz der erfindungsgemäßen Wasserstoff-Stickstoff-Chemie zum Ätzen von organischen Antireflexionsschichten kann also eine wesentlich verbesserte anisotrope Ätzung dieser Schichten gegenüber der herkömmlichen Chemie vorgenommen werden. Statt der dargestellten magnetfeldunterstützten reaktiven Ionenätzung besteht auch die Möglichkeit, andere bekannte, chemisch-physikalische Trockenätzverfahren zur Ätzung der organischen Antireflexionsschicht einzusetzen, wobei als Ätzgasgemisch Wasserstoff und Stickstoff verwendet werden. Insbesondere besteht die Möglichkeit zur Ätzung der organischen Antireflexionsschicht mit einem Wasserstoff-Stickstoff-Gasgemisch, die in den letzten Jahren entwickelten Verfahren zur verstärkten Anregung des reaktiven Gases im Plasma einzusetzen, mit denen sich höhere Ätzraten und eine verbesserte Selektivität der Ätzprozesse erzielen lassen. Hierzu zählen insbesondere die Elektronen-Zyklon-Resonanz (ECR-Plasmaquellen), das induktiv gekoppelte Plasma (ICP-Plasmaquellen) und die Helicon-Quellen.

## Patentansprüche

1. Verfahren zum anisotropen Trockenätzen einer organischen Antireflexionsschicht,
**dadurch gekennzeichnet, dass**
die Ätzgaszusammensetzung im Wesentlichen Wasserstoff und Stickstoff enthält.

2. Verfahren nach Anspruch 1, **dadurch gekennzeichnet, dass** Wasserstoff und Stickstoff im Verhältnis 1:1 verwendet werden.

3. Verfahren nach Anspruch 1 oder 2, **dadurch gekennzeichnet, dass** die Ätzgaszusammensetzung als reaktive Ätzgase mindestens 80% Wasserstoff und Stickstoff enthält.

4. Verfahren nach Anspruch 3, **dadurch gekennzeichnet, dass** die Ätzgaszusammensetzung als reaktive Ätzgase nur Wasserstoff und Stickstoff enthält.

5. Verfahren nach einem der Ansprüche 1 bis 4, **dadurch gekennzeichnet, dass** die Ätzgaszusammensetzung Additive enthält, die Ätzgaseigenschaften in Bezug auf das verwendete Trockenätzverfahren verbessern.

6. Verfahren nach einem der Ansprüche 1 bis 5, **dadurch gekennzeichnet, dass** eine Photolackschicht als Ätzmaske für die organische Antireflexionsschicht dient, wobei die Ätzgaszusammensetzung so eingestellt ist, dass der vertikale Äbbag des Photolacks maximal der Ätzrate der organischen Antireflexionsschicht entspricht.

7. Verfahren nach einem der Ansprüche 1 bis 6, **dadurch gekennzeichnet, dass** folgende Prozeßparameter zum reaktiven Ionenätzen der organischen Antireflexionsschicht eingesetzt werden:
Druck der Ätzgase im Bereich zwischen 2,67 bis 26,67 Pa (20 und 200 mTorr),
Fluss der Ätzgase im Bereich zwischen 0,17 bis 1,67 10⁻⁶ m³sec⁻¹ (10 und 100 sccm).

8. Verfahren nach Anspruch 7, **dadurch gekennzeichnet, dass** ein magnetfeldunterstütztes reaktives Ionenätzen mit einer Feldstärke von 0 bis 120 Gauss eingesetzt wird.

9. Verfahren nach einem der Ansprüche 1 bis 6, **dadurch gekennzeichnet, dass** zum Ätzen der organischen Antireflexionsschicht die Elektron-Zyklon-Resonanz-Plasmaquelle oder das induktiv gekoppelte Plasma oder die Helicon-Quelle eingesetzt wird.
